Europäisches Patentamt

European Patent Office

Office européen des brevets

(19)

(11) Numéro de publication: **0 143 041**
**A2**

(12) # DEMANDE DE BREVET EUROPEEN

(21) Numéro de dépôt: **84402264.0**

(22) Date de dépôt: **09.11.84**

(51) Int. Cl.⁴: **H 03 L 1/00**

(30) Priorité: **15.11.83 FR 8318130**

(43) Date de publication de la demande:
**29.05.85 Bulletin 85/22**

(84) Etats contractants désignés:
**CH DE GB IT LI NL SE**

(71) Demandeur: **COMPAGNIE D'ELECTRONIQUE ET DE PIEZO-ELECTRICITE - C.E.P.E.**
**44, rue de la Glacière**
**F-95100 Argenteuil(FR)**

(72) Inventeur: **Renoult, Patrick**
**THOMSON-CSF SCPI 173, bld Haussmann**
**F-75379 Paris Cedex 08(FR)**

(74) Mandataire: **Vesin, Jacques et al,**
**THOMSON-CSF SCPI 173, Bld Haussmann**
**F-75379 Paris Cedex 08(FR)**

(54) **Dispositif de compensation de la sensibilité à l'accélération d'un oscillateur.**

(57) L'invention a pour objet un dispositif de compensation de la sensibilité à l'accélération d'un oscillateur de fréquence nominale donnée.

Il comporte un élément capteur de l'accélération, par exemple un filtre 2, susceptible de produire un signal de fréquence nominale égale à celle de l'oscillateur à compenser 1, mais qui est pour ce qui concerne sa fréquence nominale, plus sensible à l'accélération que l'oscillateur à compenser 1. On compare dans un mélangeur $M_1$ la différence de phase entre la fréquence de l'oscillateur et la fréquence produite par le filtre 2 de manière à extraire la modulation de phase induite par l'accélération. Un amplificateur d'asservissement $A_1$ reçoit le signal de sortie $S_1$ du comparateur de phase $M_1$ et produit à sa sortie un signal de correction de l'oscillateur.

FIG_1

# DISPOSITIF DE COMPENSATION DE LA SENSIBILITE
## A L'ACCELERATION D'UN OSCILLATEUR

La présente invention a pour objet un dispositif de compensation de la sensibilité à l'accélération d'un oscillateur.

Les oscillateurs à cristaux piézo-électriques présentent une sensibilité aux accélérations qui se traduit par une modulation de phase du signal de sortie de l'oscillateur. Dans certaines applications, il apparaît souhaitable de compenser ce défaut, ce qui implique que l'oscillateur doit être associé à un dispositif permettant de mesurer l'accélération. Cependant, la mise en oeuvre d'un accéléromètre du type piézo-électrique impose l'utilisation d'un amplificateur à très haute impédance d'entrée, ceci afin de capter les basses fréquences. Un tel amplificateur produit du bruit de fond et des perturbations parasites produisant eux-mêmes un effet de dégradation du spectre de l'oscillateur ainsi compensé.

La présente invention a pour objet un dispositif de compensation de la sensibilité à l'accélération d'un oscillateur susceptible de produire ses effets sans dégrader le spectre de l'oscillateur.

L'invention a ainsi pour objet un dispositif de compensation de la sensibilité à l'accélération d'un oscillateur de fréquence nominale donnée caractérisé en ce qu'il comporte :

- un élément capteur susceptible de produire un signal de fréquence nominale égale à celle de l'oscillateur, mais qui est, pour ce qui concerne sa fréquence nominale, plus sensible à l'accélération que ledit oscillateur d'un facteur au moins égal à 2 ;

- un comparateur de la différence de phase existant entre la fréquence de l'oscillateur et la fréquence produite par ledit élément de manière à extraire la modulation de phase induite par l'accélération ;

- et un dispositif d'asservissement recevant le signal de sortie du comparateur de phase et produisant à sa sortie un signal de correction de l'oscillateur.

Le signal de correction peut être appliqué de manière telle qu'il modifie la phase de la boucle de contre-réaction de l'oscillateur.

Selon un mode de réalisation, le comparateur est un mélangeur recevant le signal de sortie de l'élément capteur et le signal de sortie de l'oscillateur à compenser déphasé, en l'absence d'accélération de $(2k + 1)\frac{\pi}{2}$ , où k est un nombre entier ou nul. Ledit déphasage de $(2k + 1)\frac{\pi}{2}$ peut être obtenu par une longueur de ligne disposée entre la sortie de l'oscillateur à compenser et l'entrée correspondante du mélangeur.

Selon une première variante, ledit élément capteur est un filtre dont l'entrée est alimentée par la sortie de l'oscillateur à compenser.

Selon une deuxième variante, ledit élément capteur est un second oscillateur. Le dispositif peut alors comporter un dispositif de correction de la dérive de fréquence du second oscillateur par rapport à l'oscillateur à compenser, ce dispositif de correction comportant par exemple un second mélangeur recevant les sorties de chacuns des oscillateurs déphasés 2h x π, où h est un nombre entier ou nul, et dont la sortie amplifiée constitue un signal de correction de dérive du second oscillateur. Le signal de correction de dérive peut être alors appliqué de manière telle qu'il modifie la phase de la boucle de contre-réaction du second oscillateur.

L'invention sera mieux comprise à la lecture de la description qui va suivre, donnée à titre d'exemple non limitatif, en liaison avec les dessins qui représentent :

- la figure 1, un dispositif de compensation mettant en oeuvre un filtre capteur selon un premier mode de réalisation de l'invention ;

- les figures 2a à 2d, différentes variantes de filtres capteurs ;

- la figure 3, un dispositif de compensation selon une deuxième variante de l'invention mettant en oeuvre un deuxième oscillateur faisant fonction de capteur d'accélération.

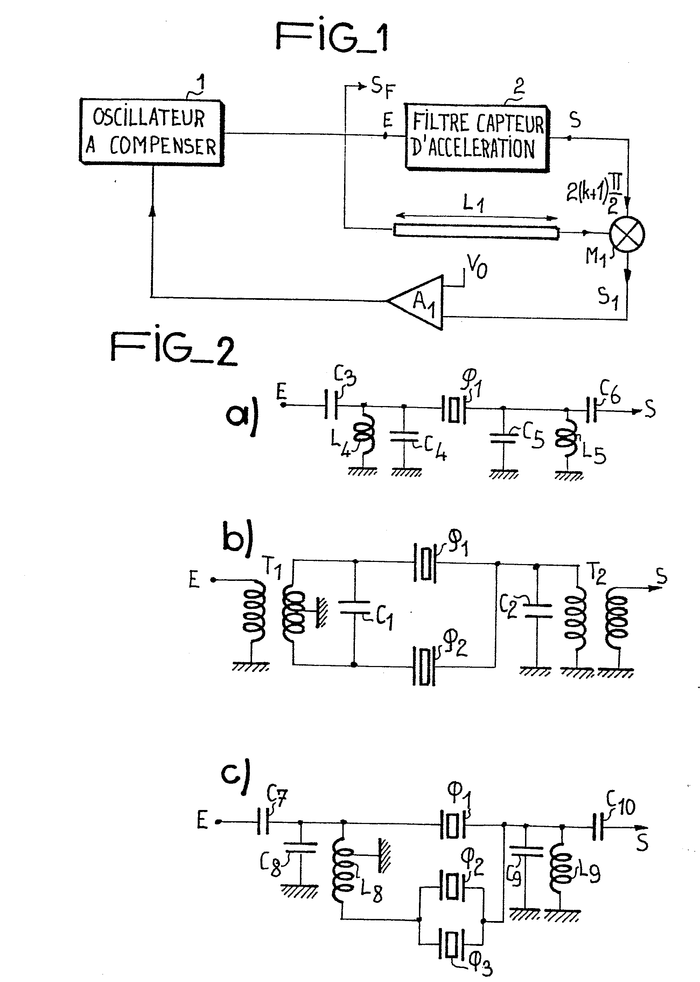

Selon la figure 1, le signal de sortie $S_F$ de même fréquence nominale que celle de l'oscillateur 1, et d'un oscillateur 1 à compenser est appliqué à l'entrée d'un filtre 2 qui présente une sensibilité importante à l'accélération, supérieure d'au moins un facteur 2 à la sensibilité à l'accélération de l'oscillateur 1 à compenser. L'oscillateur 1 et le filtre 2 sont disposés de manière telle qu'ils soient soumis aux mêmes accélérations. Par exemple, pour un quartz, il existe des rapports de l'ordre de 2 à 3 entre la coupe la plus sensible à l'accélération (coupe AT) qui peut convenir pour le filtre, et la ou les coupes les moins sensibles à l'accélération, lesquelles conviennent pour réaliser le cristal de l'oscillateur à compenser.

D'autre part, le tantalate de lithium présente une sensibilité à l'accélération nettement plus forte que le quartz (d'environ un facteur 10). Ce matériau convient donc tout particulièrement pour réaliser le filtre.

En présence d'accélérations, on recueille à la sortie du filtre 2 un signal de sortie S modulé en phase par rapport au signal qui était appliqué à son entrée. Cette modulation de phase est détectée par un mélangeur $M_1$ recevant à ses entrées respectivement l'entrée du filtre 2 c'est-à-dire la sortie de l'oscillateur 1 et la sortie du filtre 2. Plus particulièrement, la détection de la modulation de phase est obtenue en construisant le dispositif de manière telle que, en l'absence d'accélération, les signaux appliqués aux deux entrées du mélangeur $M_1$ soient déphasés de $(2k + 1)\frac{\pi}{2}$, où k est un nombre entier ou nul. Ce décalage de phase peut être obtenu par une ligne de longueur L convenable interposée entre la sortie de l'oscillateur 1 et l'entrée correspondante du mélangeur $M_1$.

Le signal de sortie $S_1$ du mélangeur $M_1$ est introduit à une entrée d'un amplificateur opérationnel $A_1$. L'amplificateur $A_1$ reçoit à son autre entrée une tension de consigne $V_0$ qui a pour valeur celle du signal $S_1$ lorsque le filtre n'est soumis à aucune accélération. En effet, par principe, le mélangeur $M_1$ délivre un signal égal à la moitié de sa valeur nominale maximale lorsque les deux signaux présents à ses entrées sont déphasés exactement de $(2k + 1)\frac{\pi}{2}$. En présence d'accélérations, le signal $S_1$ évolue autour de cette valeur.

Le signal de sortie de l'amplificateur opérationnel $A_1$ est introduit dans l'oscillateur à compenser et est appliqué à celui-ci de manière telle qu'il modifie la phase de la boucle de contre-réaction de l'oscillateur. Cette correction, qui peut être effectuée classiquement par commande d'une diode Varicap disposée en série ou en parallèle dans la boucle de contre-réaction de l'oscillateur, a pour effet de faire varier légèrement la fréquence nominale de celui-ci, ce qui produit une compensation des effets de l'accélérations. En effet, la modulation de phase produite par les accélérations est équivalente en première approximation à une modification de la fréquence de l'oscillateur.

Selon la figure 2a, le filtre 2 comporte un quartz $Q_1$. Plus précisément, il comporte un condensateur d'adaptation d'impédance $C_3$ monté en série à partir de son entrée E et un condensateur d'adaptation d'impédance $C_6$ monté en série à partir de sa sortie S. Le quartz $Q_1$, monté en série entre les condensateurs $C_3$ et $C_6$, présente à ses bornes des réseaux d'adaptation de fréquence réglés sur la fréquence du quartz $Q_1$. Ces réseaux sont constitués par des couples self-capacité montés en parallèle entre les extrémités du quartz $Q_1$ et la masse, respectivement $L_4$ et $C_4$ du côté de l'entrée E et $C_5$ et $L_5$ du côté de la sortie S. Ces réseaux d'impédance permettent d'augmenter la sélectivité du filtre.

Selon la variante de la figure 2b, le filtre 2 comporte deux quartz $Q_1$ et $Q_2$ de même fréquence nominale que l'oscillateur 1, mais orientés dans l'espace de telle sorte qu'ils soient sensibles à l'accélération dans des directions différentes, par exemple orthogonales. Le filtre comporte à son entrée E un transformateur d'adaptation d'impédance $T_1$ dont le secondaire présente un point milieu à la masse, et à sa sortie S un transformateur d'adaptation d'impédance $T_2$. Aux bornes du secondaire du transformateur $T_1$ et du primaire du transformateur $T_2$, sont branchés des condensateurs, respectivement $C_1$ et $C_2$ formant avec respectivement le secondaire et le primaire correspondant des cricuits accordés à la fréquence commune des quartz $Q_1$ et $Q_2$, de manière à augmenter la sélectivité du filtre. Une extrémité de chacun des quartz $Q_1$ et $Q_2$ est raccordée à une extrémité du secondaire du transformateur $T_1$, alors que les quartz $Q_1$ et $Q_2$ sont connectés au niveau de leur autre borne, laquelle est reliée à une extrémité du secondaire du transformateur $T_2$, l'autre extrémité du transformateur $T_2$ étant à la masse.

Selon la figure 2c, le filtre 2 comporte trois quartz $Q_1$, $Q_2$ et $Q_3$ montés en parallèle et qui sont chacun de même fréquence nominale que l'oscillateur 1. Le filtre comporte des condensateurs série d'adaptation d'impédance, respectivement $C_7$ du côté de l'entrée E et $C_{10}$ du côté de la sortie S. A l'entrée et à la sortie sont prévus des réseaux d'adaptation en fréquence pour améliorer la sélectivité du filtre. Ceux-ci consistent du côté de l'entrée E en un condensateur $C_8$ monté en parallèle et dont une extrémité est à la masse, et en une self $L_8$ dont un point milieu est à la masse, et du côté de la sortie par un condensateur $C_9$ et une self $L_9$ branchés en parallèle et dont une borne est à la masse. Le quartz $Q_1$ est branché à une extrémité à la borne commune aux condensateurs $C_7$ et $C_8$ et à la self $L_8$. Les quartz $Q_2$ et $Q_3$ ont une première borne commune raccordée à l'autre extrémité de la self $L_8$, et les deuxièmes bornes des quartz $Q_1$, $Q_2$ et $Q_3$ sont connectées entre elles à la borne non à la masse de condensateur $C_9$ et de la self $L_9$.

Selon la figure 2d, le filtre 2 comporte trois quartz $Q_1$, $Q_2$ et $Q_3$ branchés en série. Le filtre comporte des transformateurs d'adaptation respectivement d'entrée $T_1$ et de sortie $T_2$. Aux bornes du secondaire du transformateur $T_1$ est branché un condensateur $C_{11}$ formant avec celui-ci un circuit d'accord à la fréquence commune des quartz $Q_1$, $Q_2$ et $Q_3$ de manière à améliorer la sélectivité du filtre. Il en va de même pour le condensateur $C_{14}$ qui est branché aux bornes du primaire du transformateur de sortie $T_2$. Une adaptation d'impédance est réalisée par des condensateurs $C_{12}$ et $C_{13}$ raccordés à la borne commune respectivement aux quartz $Q_1$ et $Q_2$, et aux quartz $Q_2$ et $Q_3$.

6

Selon l'invention, chacun des trois quartz des filtres décrits aux figures 2c et 2d est orienté dans une direction différente de sensibilité à l'accélération, par exemple les trois axes d'un trièdre. Ceci permet de réaliser une compensation pour les accélérations dans toutes les directions de l'espace.

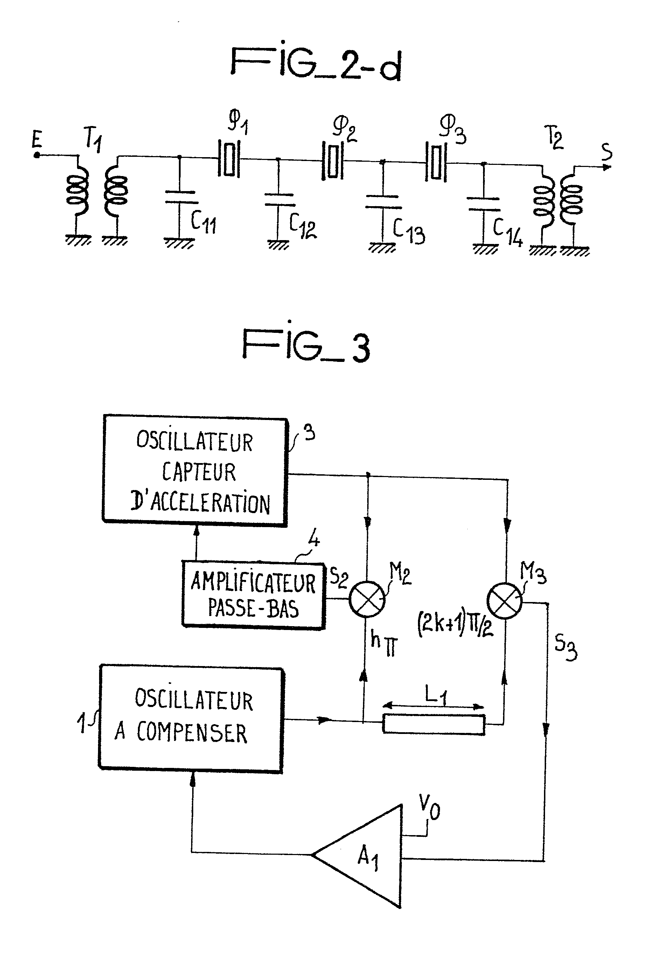

Selon la figure 3, le capteur d'accélération est un oscillateur 3 de même fréquence que l'oscillateur à compenser 1. Le cristal de l'oscillateur 3 est un quartz de coupe AT afin d'obtenir une bonne sensibilité aux accélérations, ou mieux encore il est réalisé en tantalate de lithium. La sortie des oscillateurs 1 et 3 est introduite chacune à une entrée d'un mélangeur $M_3$. Ils sont reliés de telle manière que, en l'absence d'accélération le déphasage entre les deux entrées du mélangeur $M_3$ soit égale à $(2k + 1)\frac{\pi}{2}$ , où k est un nombre entier ou nul. Ce décalage de phase est obtenu par exemple par une ligne de longueur $L_1$ interposée entre la sortie de l'oscillateur 1 et l'entrée correspondante du mélangeur $M_3$. La sortie du mélangeur $M_3$ attaque une entrée d'un amplificateur opérationnel $A_1$ dont l'autre entrée reçoit un signal de consigne $V_0$ dont la valeur est égale à celle du signal $S_3$ en l'absence d'accélération. La sortie de l'amplificateur $A_1$ est introduite dans l'oscillateur à compenser de manière à agir sur la phase de la boucle de contre-réaction de celui-ci. La compensation de l'oscillateur se fait donc à partir du mélangeur $M_3$ comme dans le cas de la figure 1.

Ce montage peut être amélioré grâce à un montage particulier. En effet, l'oscillateur à compenser est en général un oscillateur thermostaté de hautes performances. Si on veut que la compensation de l'accélération soit optimale, il faut que l'oscillateur capteur soit lui-même stable autant que l'est l'oscillateur à compenser 1. Pour cette raison, il est avantageux d'introduire un mélangeur $M_2$ recevant la sortie des deux oscillateurs 1 et 3, mais déphasée de $h\pi$, où h est un nombre entier ou nul. Le mélangeur délivre alors à sa sortie $S_2$ un signal représentant l'écart de fréquence entre les deux oscillateurs 1 et 3. Le signal $S_2$ est introduit à l'entrée d'un amplificateur passe bas 4 dont la sortie attaque l'entrée de commande de fréquence de l'oscillateur capteur d'accélération, de manière à asservir la fréquence de l'oscillateur 3 sur celle de l'oscillateur 1. La présence d'un filte passe-bas dans l'amplificateur 4 a pour objet de limiter la compensation de la fréquence de l'oscillateur 3 aux dérives thermiques très lentes. En effet, ainsi qu'on l'a dit plus haut, la modulation de phase introduite par les accélérations est équivalente à une variation de fréquence de l'oscillateur 3 et il convient donc de séparer ces deux paramètres grâce au filtre passe-bas 4.

8

# R E V E N D I C A T I O N S

1. Dispositif de compensation de la sensibilité à l'accélération d'un oscillateur de fréquence nominale donnée caractérisé en ce qu'il comporte :

- un élément capteur (2, 3) susceptible de produire un signal de fréquence nominale égale à celle de l'oscillateur, mais qui est, pour ce qui concerne sa fréquence nominale, plus sensible à l'accélération que ledit oscillateur d'un facteur au moins égal à 2 ;

- un comparateur $(M_1, M_3)$ de la différence de phase existant entre la fréquence de l'oscillateur (1) à compenser et la fréquence produite par ledit élément de manière à extraire la modulation de phase induite par l'accélération ;

- et un dispositif d'asservissement $(A_1 \ A_2)$ recevant le signal de sortie $(S_1, S_3)$ du comparateur de phase $(M_1, M_3)$ et produisant à sa sortie un signal de correction de l'oscillateur.

2. Dispositif selon la revendication 1, caractérisé en ce que ledit signal de correction est appliqué de manière telle qu'il modifie la phase de la boucle de contre-réaction de l'oscillateur (1) à compenser.

3. Dispositif selon une des revendications 1 ou 2, caractérisé en ce que ledit comparateur est un mélangeur $(M_1, M_3)$ recevant le signal de sortie (S) de l'élément capteur (2, 3) et le signal de sortie de l'oscillateur à compenser (1) déphasés, en l'absence d'accélération de $(2k + 1)\frac{\pi}{2}$, où k est un nombre entier ou nul.

4. Dispositif selon la revendication 3, caractérisé en ce que ledit déphasage de $(2k + 1)\frac{\pi}{2}$ est obtenu par une longueur de ligne $(L_1, L_2)$ disposée entre la sortie de l'oscillateur à compenser et l'entrée correspondante du mélangeur $(M_1, M_3)$.

5. Dispositif selon une des revendications précédentes, caractérisé en ce que ledit élément capteur (2, 3) est un filtre (2) dont l'entrée est alimentée par la sortie dudit oscillateur à compenser (1).

6. Dispositif selon la revendication 5, caractérisé en ce que le filtre comporte au moins un résonateur ($Q_1$, $Q_2$, $Q_3$) orienté suivant une direction donnée de sensibilité privilégiée à l'accélération.

7. Dispositif selon une des revendications 1 à 4, caractérisé en ce que ledit élément capteur (2, 3) est un second oscillateur (3).

8. Dispositif selon la revendication 7, caractérisé en ce qu'il comporte un dispositif de correction ($M_2$, 4) de la dérive de fréquence du second oscillateur par rapport à l'oscillateur à compenser.

9. Dispositif selon la revendication 8, caractérisé en ce que ledit dispositif de correction de dérive comporte un second mélageur ($M_2$) recevant les sorties de chacune des oscillateurs, déphasées de $h\pi$, où h est un nombre entier ou nul, et dont la sortie amplifiée constitue un signal de correction de dérive du second oscillateur.

10. Dispositif selon la revendication 9, caractérisé en ce que ledit signal de correction de dérive est appliqué de manière telle qu'il modifie la phase de la boucle de contre-réaction du second oscillateur (3).

11. Dispositif selon une des revendications précédentes, caractérisé en ce que l'oscillateur (1) à compenser est un oscillateur à quartz et en ce que l'élément capteur (2, 3) est un filtre ou un oscillateur au tantalate de lithium ou à quartz suivant la coupe AT.

FIG_1

FIG_2

# FIG_2-d

# FIG_3